# EUROPEAN PATENT APPLICATION

(11) **EP 4 617 680 A1**
(43) Date of publication of application: **17.09.2025**
(21) Application number: 23888168.4
(22) Date of filing: 10.11.2023
(51) Int. Cl.: G01R 15/20, G01R 19/00, H02B 1/20

(54) **ELECTRICAL CURRENT SENSOR**

(30) Priority: 11.11.2022 ES 202230975
(71) Applicant: Piher Sensors & Controls, S.A., 31500 Tudela (Navara) (ES)
(72) Inventor: PÉREZ CIAURRIZ, David, 31500 Tudela (ES); RUIZ RODERO, Koldo, 31500 Tudela (ES); VANNESTE, Bram Erik, 31500 Tudela (ES); NUECHTER, Peter, 31500 Tudela (ES); MILEWSKI, Joe, 31500 Tudela (ES)
(86) International application number: PCT/ES2023/070670
(87) International publication number: WO 2024/100317

(57) **Abstract**

The invention relates to a current sensor formed by an integrated circuit (6), preferably of the TMR magnetic type, mounted on a PCB (5) and also comprising additional circuitry to protect the sensor from possible surges and electrical and electromagnetic noise, thus providing electromagnetic immunity. All these components are mounted in a casing (1) typically made of plastic, preferably with an opening for connecting the system. An electrically conductive bar or busbar (4) may be inserted through the casing to allow the circulation of the electrical current to be measured. The sensor provides an analogue output proportional to the current of an electrical conductor inserted through the casing.

## Description

### PURPOSE OF THE INVENTION

The present invention relates to an electrical current sensor whose purpose is to provide a more precise, faster, smaller, lighter sensor with lower energy consumption, better linearity, greater stability, high electromagnetic immunity, and reduced manufacturing cost.

### BACKGROUND TO THE INVENTION

Electric vehicles use a different automotive technology compared to that used by conventional vehicles. Electric and hybrid electric vehicles use numerous applications where electric current measurement is necessary, such as in DC-DC converters, systems like the Battery Management System (BMS), current inverters, or the vehicles' electric traction systems, among others, in addition to systems associated with electrification, such as the various types of wall chargers and on-board chargers.

The performance of electric vehicles depends on the vehicle's battery, with current sensors being responsible for detecting the current in batteries, identifying overloads, helping to reduce emission levels, and controlling the circulation of electrical energy within the vehicle. Therefore, with the ongoing drive towards vehicle electrification, technological advancements in this automotive component are critical and essential.

### DESCRIPTION OF THE INVENTION

It should be noted that current sensors need to be increasingly more accurate, faster, smaller and have lower energy consumption. This makes it necessary to use technologies that are different from those commonly used. In addition, it is necessary to take into account that the sensors are situated in environments with a lot of electromagnetic noise, with continuous high-power electrical switching and a large number of metallic elements, which generate large disturbances and can lead to malfunctioning or render the sensor inoperative. It is therefore imperative to design a sensor with high electromagnetic immunity.

The electrical current sensor proposed in the invention can solve the above-mentioned problems, based on a highly effective solution.

In some configurations, an electrical current sensor (AC or DC) is capable of measuring the circulation of current through an electric conductor, for example a busbar. The busbar may pass through the casing or be positioned next to the casing.

The sensor can be used to measure the current in high current and high voltage systems, battery management applications, DC/DC converters or inverters, providing a fully insulated contact free measurement system.

The sensor can be comprised of a magnetoresistive type integrated circuit such as TMR, GMR or AMR, or a Hall effect type magnetic integrated circuit, mounted on a PCB, also comprising additional circuitry to protect the sensor from possible surges, and electrical and electromagnetic noise, thus providing electromagnetic immunity.

These components can be mounted in a plastic casing, designed to facilitate a connector through an opening or with an integrated connector for system wiring, a connector which is not necessary when the communication is wireless by radio frequency.

An electrically conductive bar or busbar may be inserted through the casing to allow the circulation of the electric current to be measured. The busbar or electric conductor may be attached to the casing or separate from it. In some cases the casing is attachable to an electrically conductive bar.

The sensor may include an analogue output proportional to the current of an electric conductor inserted through the casing. At this point it should be added that it is possible to use digital outputs such as CAN, SENT or LIN, as well as the possibility of including additional functionalities such as temperature measurement and transmission of this data by analogue or digital communication.

Temperature measurement is a functionality that can be added to the sensor to check for possible overheating of the busbar and therefore a malfunction of the electrical system.

### DESCRIPTION OF THE DRAWINGS

To complement the description given below and with the aim of providing a better understanding of the characteristics of the invention, in line with a preferred example of a practical embodiment thereof, a set of drawings is included as an integral part of said description, for illustrative and non-limiting purposes:

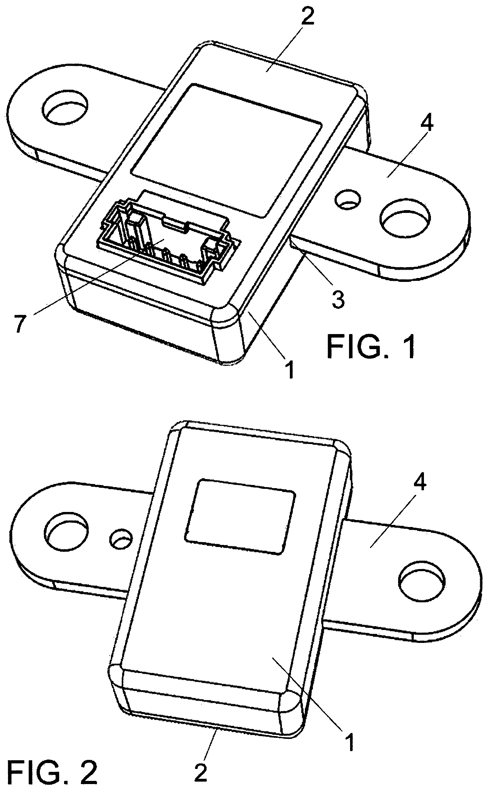

Figure 1.- Shows a perspective view of an electrical current sensor made in accordance with the object of the present invention.
Figure 2.- Shows a view of the assembly in figure 1 in reverse perspective.

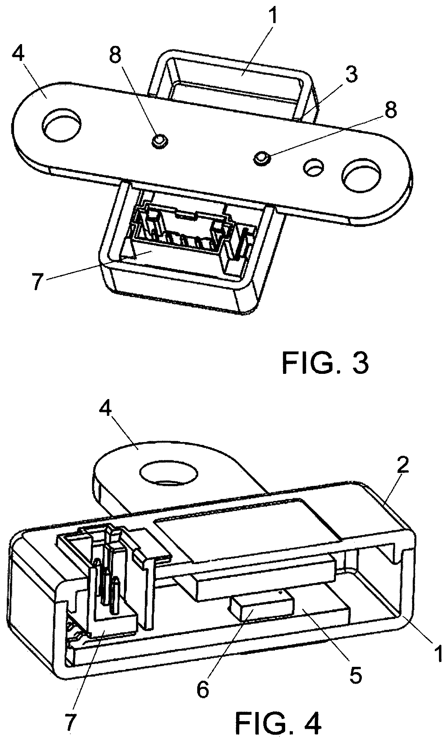

Figure 3.- Shows a view similar to that of figure 1, but with the casing of the device without its top cover.
Figure 4.- Shows a longitudinal section view of the device.
Figure 5.- Shows an exploded view of one way of applying the busbar or conductor whose current is to be measured by the sensor of the invention.
Figure 6.- Shows a view similar to that of figure 5, but corresponding to a variant embodiment in which the means of sensorization are duplicated for the same busbar or conductor whose current is to be measured.
Figure 7.- Shows a view similar to that of figure 1, but corresponding to a variant embodiment in which the sensor is capable of independently measuring the current circulating through several busbars or conductors.
Figure 8.- Shows a longitudinal section view of the assembly in figure 7.

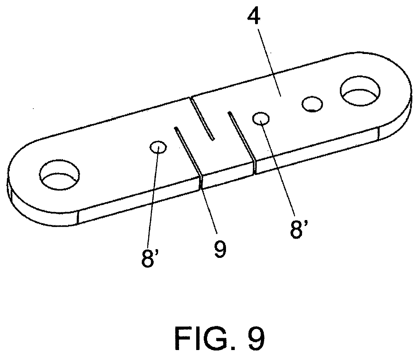

Figure 9.- Finally shows a detailed perspective of a possible realisation for the busbar used in the sensor of the invention.

### PREFERRED EMBODIMENT OF THE INVENTION

In view of the aforementioned figure, it can be seen how the sensor of the invention is made up of a casing (1), preferably made of plastic, fitted with a closing cover (2), and at least one opening (3) between the two for the insertion of at least one electric conductor or busbar (4).

Inside the casing (1) there is a printed electronic circuit or PCB (5) on which at least one TMR (6) magnetoresistive integrated circuit is mounted (one for each opening (3) for the insertion of the corresponding electric conductor or busbar (4)), strategically placed in a central position and keeping a fixed distance from the electric conductor or busbar (4) and through which the electric current to be measured circulates, thus achieving a non-intrusive, contact-free measurement system.

The sensor does not require a magnetic concentrate system, of an electromagnetic core type, although an electromagnetic concentrator may be used in some cases. The system comprising a magnetoresistive type integrated circuit also known as Tunnel Magneto-resistance or TMR (6) and an electric conductor or busbar (4) guarantees the same arrangement and distance throughout the useful life of the sensor, using fastening devices for the PCB (5) and Busbar.

The PCB (5) includes additional circuitry to protect the sensor from surges, and electrical and electromagnetic noise.

The busbar (4) through which the electric current circulates will be made of materials with high electrical conductivity, generally copper or aluminium.

The busbar may be integrated in the sensor, connected at lugs (8), through holes (8'), depending on the application, forming part of the sensor or the sensor may have a fastening system, such as clamp-on, screw or similar that allows the sensor to be attached to a busbar external to the sensor.

A special design of the busbar is possible, based on an elongated laminar body in which strategically placed cuts (9) are made, arranged transversally and in a staggered pattern, so that the current circulates in a U-shape which will generate two magnetic fields of equal and opposite magnitude resulting in a measurement of the magnetic field free of external influences, measuring the algebraic difference between the values of these two magnitudes.

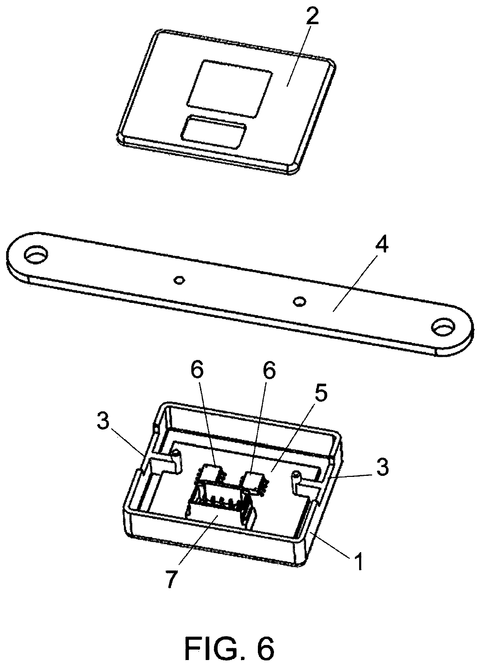

According to the variant embodiment of figure 6, it is possible to use two magnetic type integrated circuits mounted on the PCB positioned inside the same sensor.

These can be placed in the same direction allowing the calculation of the arithmetic average of the values obtained. They may also be placed in opposite direction, obtaining opposite magnitudes that allow the measurement of the difference in the magnetic field generated by the busbar (4) and the elimination of any noise or external magnetic field.

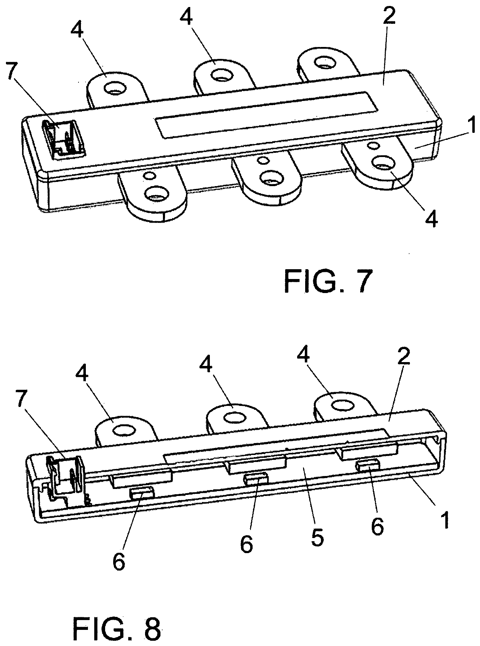

According to the variant embodiment of figures 7 and 8, in applications where it is necessary to measure the current circulating through more than one busbar in parallel, generally the three phases used in electric vehicle propulsion systems, 3 integrated circuits of the TMR magnetic type (6), one for each busbar (4), integrated within the same device or sensor, will be used. In other cases, the sensor may include two busbars and their corresponding TMR integrated circuits (6), or more than three busbars and their corresponding number of TMR integrated circuits (6).

The PCB includes a connector (7) with which the value of the current circulating through the sensor is obtained, preferably by means of analogue signal condition proportional to the current.

Optionally, this measurement can be sent using other means and digital communication protocols such as CAN or LIN. It is even possible to use RF wireless technology to communicate the value of the current.

Returning again to the casing (1) cover (2) assembly, these elements will be attached by means of ultrasound or other means of fastening (such as mechanical fasteners or adhesives) having already inserted the busbar (4) between them, although it is possible to remove the cover from the casing and fill the device with an epoxy type or hot-melt resin that provides the system with protection from dust, humidity and external agents.

The device has a connector (7) with access through an opening or integrated in the casing itself for connecting the system. This connector may not be necessary in the event of RF Wireless technology.

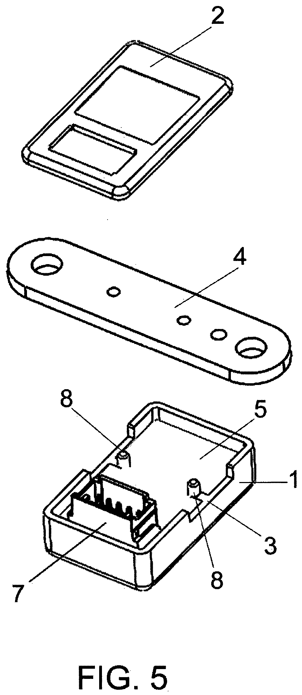

Referring to Figure 5, the sensor does not include an integrated busbar, but the sensor is configured to be coupled near or directly to an external busbar. For example, a busbar located in an electric-vehicle charging station. The sensor may include a casing configured to be coupled to the busbar or other fastening component or adapter in close proximity to the busbar. This adapter and the casing must ensure the direction with respect to the electric conductor or busbar. The shape of this adapter may correspond to the shape of the busbar, facilitating correct fastening.

The sensor obtained as a result is an improvement on the current ones in the market as it is more precise, has better linearity and is faster. The elimination of the magnetic concentrator makes it smaller, lighter and cheaper to manufacture.

## Claims

1. Electrical current sensor, **characterised in that** it is made up of a casing (1), preferably made of plastic, provided with a cover (2) or closing element, with at least one opening (3) between the two for the insertion from one end of the casing to the other of at least one electric conductor or busbar (4) whose current is to be measured, it being foreseen that inside the casing (1) there is a printed electronic circuit or PCB (5) on which is mounted at least one integrated circuit for detecting electric current, preferably of the TMR tunnel magneto-resistance type (6), facing and at a fixed distance from the electric conductor or busbar (4), a PCB which includes a connector (7) to obtain the value of the current circulating through the sensor.

2. Electrical current sensor, according to claim 1, **characterised in that** the integrated circuit (6) is of other magnetic technologies such as HALL.

3. Electrical current sensor, according to claim 1, **characterised in that** the busbar (4) is integrated in the sensor, including a fastening and positioning system, either lug type, screw or similar, for fastening between the casing or the PCB and an integrated busbar.

4. Electrical current sensor, according to claim 1, **characterised in that** the busbar (4) is independent of the sensor, and is attached to it by means of conventional clamp-on, screw or similar type systems.

5. Electrical current sensor, according to claim 1, **characterised in that** the busbar (4) is external to the sensor without passing through it, the sensor preferably being coupled to the busbar by means of screws.

6. Electrical current sensor, according to claim 1, **characterised in that** the busbar (4) is made of materials with high electrical conductivity such as copper or aluminium.

7. Electrical current sensor, according to claim 1, **characterised in that** the busbar (4) takes the form of an elongated laminate body, with cuts (9) arranged transversely and in a staggered pattern.

8. Electrical current sensor, according to claim 1, **characterised in that** the PCB includes two magnetic type integrated circuits (6) placed in the same direction with respect to the busbar (4).

9. Electrical current sensor, according to claim 1, **characterised in that** the PCB includes two magnetic type integrated circuits (6) placed in opposite direction with respect to the busbar (4).

10. Electrical current sensor, according to claim 1, **characterised in that** the PCB includes 3 magnetic type integrated circuits (6) associated to three independent busbars (4) of a three-phase circuit.

11. Electrical current sensor, according to claim 1, **characterised in that** the output is materialized via a connector (7) with analogue signals of the value of the current circulating through the sensor.

12. Electrical current sensor, according to claim 1, **characterised in that** the output includes digital communication signals such as CAN, LIN or similar to transmit the value of the current circulating through the sensor.

13. Electrical current sensor, according to claim 1, **characterised in that** the output includes a radio frequency communications module for the transmission of the value of the current circulating through the sensor.

14. Electrical current sensor, according to claim 1, **characterised in that** the sealing element of the casing (1) is made of an epoxy type or hot-melt resin to fill the casing.

15. Electrical current sensor, according to claim 1, **characterised in that** the PCB (5) includes additional circuitry to protect the sensor from surges, and electrical and electromagnetic noise.

16. Electrical current sensor, according to claim 1, **characterised in that** the PCB (5) includes additional circuitry for temperature sensing.
